# EUROPEAN PATENT APPLICATION

(11) **EP 4 852 675 A1**
(43) Date of publication of application: **09.12.2026**
(21) Application number: 25767186.7
(22) Date of filing: 19.02.2025
(51) Int. Cl.: H10K 30/86

(54) **PEROVSKITE BATTERY AND PREPARATION METHOD THEREFOR, PHOTOVOLTAIC MODULE, PHOTOVOLTAIC SYSTEM, ELECTRIC DEVICE, AND POWER GENERATING DEVICE**

(30) Priority: 07.03.2024 CN 202410264091
(71) Applicant: Contemporary Amperex Technology Co., Limited, Ningde, Fujian 352100 (CN)
(72) Inventor: ZHANG, Fan, Ningde, Fujian 352100 (CN); XIANG, Ling, Ningde, Fujian 352100 (CN); LIN, Xiangling, Ningde, Fujian 352100 (CN); LIN, Zuchao, Ningde, Fujian 352100 (CN); LI, Hanfang, Ningde, Fujian 352100 (CN); LIANG, Jianghu, Ningde, Fujian 352100 (CN); SU, Shuojian, Ningde, Fujian 352100 (CN)
(74) Representative: Lorenz Seidler Gossel Part. mbB
(86) International application number: PCT/CN2025/078021
(87) International publication number: WO 2025/185446

(57) **Abstract**

The present application relates to a perovskite battery and a preparation method therefor, a photovoltaic module, a photovoltaic system, an electric device, and a power generating device. The perovskite battery comprises a first electrode layer, a hole transport layer, a perovskite layer and a second electrode layer; the hole transport layer is arranged on one side of the first electrode layer, and the hole transport layer comprises nickel oxide and reducing cations; the perovskite layer is arranged on the side of the hole transport layer away from the first electrode layer; the second electrode layer is arranged on the side of the perovskite layer away from the hole transport layer. The perovskite layer in the perovskite battery of the present application has good long-term stability, and the perovskite battery has a long service life.

## Description

### CROSS-REFERENCE TO RELATED APPLICATIONS

The present application claims priority to Chinese Patent Application 2024102640913, filed on March 7, 2024 and entitled "PEROVSKITE CELL AND PREPARATION METHOD THEREFOR, PHOTOVOLTAIC MODULE, PHOTOVOLTAIC SYSTEM, ELECTRICAL APPARATUS, AND POWER GENERATION APPARATUS", which is incorporated herein by reference in its entirety.

### TECHNICAL FIELD

The present application relates to the field of solar cells, and specifically to a perovskite cell and a preparation method therefor, a photovoltaic module, a photovoltaic system, an electrical apparatus, and a power generation apparatus.

### BACKGROUND

With the rapid development of new energy field, solar cells have been widely used in the fields such as aerospace, industry, commerce, agriculture and communications. Perovskite solar cells are apparatuses that convert solar energy into electrical energy through a photoelectric conversion mechanism of perovskite crystal materials, and they are currently the third generation of solar cells and have many advantages such as high photoelectric conversion efficiency, simple manufacturing process, and low production cost; and they have been extensively studied in recent years.

However, existing perovskite cells typically suffer from poor long-term stability of perovskite layers, resulting in short service lives and severely hindering the industrial application. Therefore, improving the long-term stability of the perovskite layers and prolonging the service lives of the batteries has become one of the important research directions in this field.

### SUMMARY

The present application is proposed in view of the above problems, and one objective is to provide a perovskite cell in which a perovskite layer has a good long-term stability, and the perovskite cell has a long service life.

In order to achieve the above objective, in a first aspect, the present application provides a perovskite cell, including:
a first electrode layer;
a hole transport layer which is arranged on one side of the first electrode layer and includes nickel oxide and reducing cations;
a perovskite layer which is arranged on a side of the hole transport layer facing away from the first electrode layer; and
a second electrode layer which is arranged on a side of the perovskite layer facing away from the hole transport layer.

In the perovskite cell described in the present application, the reducing cations refer to cations that lose electrons in a chemical reaction; the reducing cations in the present application are optionally reducing cations that can reduce high-valence nickel ions, and the valence of the high-valence nickel ions is greater than or equal to +3; in the present application, the reducing cations that can reduce the high-valence nickel ions are added to the hole transport layer; and the reducing cations can be subjected to a redox reaction with the high-valence nickel ions in the hole transport layer so as to convert the high-valence nickel ions into low-valence nickel ions, which alleviates the degradation problem of perovskite caused by the high-valence nickel ions contacting a perovskite light-absorbing layer, and improves the long-term stability of the perovskite layer, thereby prolonging the service life of the perovskite cell.

In any embodiment, the reducing cations include lanthanide metal ions.

In any embodiment, the lanthanide metal ions include one or more of Eu²⁺, Yb²⁺, Sm²⁺, Ce³⁺, Tb³⁺, or Pr³⁺. The lanthanide metal ions can effectively reduce the high-valence nickel ions in the hole transport layer to the low-valence nickel ions, thereby effectively alleviating the degradation of perovskite.

In any embodiment, a concentration of the reducing cations on the side of the hole transport layer facing away from the first electrode layer is greater than the concentration of the reducing cations on the side of the hole transport layer facing the first electrode layer. Therefore, the reducing cations are mainly located on the side of the hole transport layer facing the perovskite layer, thus better alleviating the degradation of perovskite.

In any embodiment, the nickel oxide further includes doped cations. Thus, the doped cations enables distorting in a lattice of nickel oxide, which causes defects in a nickel oxide crystal, thereby increasing a hole mobility of the hole transport layer, and consequently improving the photoelectric conversion efficiency and fill factors of the perovskite cell.

In any embodiment, the doped cations include one or more of Li⁺, Cs⁺, Rb⁺, Ag⁺, Mg²⁺, Ca²⁺, Zn²⁺, Sr²⁺, Ba²⁺, Fe²⁺, Fe³⁺, Co²⁺, Co³⁺, Cu⁺, Eu³⁺, Yb³⁺, Sm²⁺, Ce⁴⁺, Tb⁴⁺, Pr⁴⁺, Cu²⁺, or Nd³⁺. The doped cations are added to the hole transport layer to effectively improve the hole mobility of the hole transport layer.

In any embodiment, the hole transport layer includes a direct contact layer at the side facing the perovskite layer, and a non-direct contact layer at the side away from the perovskite layer; the direct contact layer includes nickel oxide and the reducing cations; and the non-direct contact layer includes nickel oxide. The reducing cations can reduce the high-valence nickel ions at an interface of the hole transport layer close to the perovskite layer without excessively affecting the high-valence nickel ions in the hole transport layer, thus the degradation problem of perovskite caused by deprotonation reaction when the high-valence nickel ions at the interface contact the perovskite layer can be reduced, and meanwhile, the promoting effect of high-valence nickel ions in the hole transport layer on hole transport cannot be influenced.

In any embodiment, at least 60% of the reducing cations are distributed in the direct contact layer. Thus, at least 60% of the reducing cations distributed in the direct contact layer can reduce the high-valence nickel ions at the interface of the whole transport layer close to the perovskite layer without excessively affecting the high-valence nickel ions in the whole transport layer.

In any embodiment, a thickness of the direct contact layer is 0.1-20 nm, optionally, 0.1-10 nm, or optionally 2-10 nm. In this way, the reducing cations can reduce the high-valence nickel ions at the interface, so as to reduce the damage to the perovskite layer material, as well as avoiding excessive impact on the promoting effect of the high-valence nickel ions in the hole transport layer on hole transport.

In any embodiment, a molar ratio of the reducing cations to a nickel element in the direct contact layer is (0.0001-0.2):1, optionally, (0.002-0.05):1. Thus, by controlling the molar ratio of the reducing cations to nickel within the above range, the degradation of perovskite can be effectively alleviated, and the service life of the perovskite cell can be prolonged.

In any embodiment, the hole transport layer further includes an indirect contact layer which is located between the direct contact layer and the non-direct contact layer; the indirect contact layer includes nickel oxide and the reducing cations, or the indirect contact layer includes nickel oxide, the reducing cations, and the doped cations. Thus, the reducing cations can reduce the high-valence nickel ions in nickel oxide; in a case that the indirect contact layer includes the doped cations, the doped cations enables distorting in a lattice of nickel oxide, which causes defects in a nickel oxide crystal, thereby increasing a hole mobility of the hole transport layer, and consequently improving the photoelectric conversion efficiency and fill factors of the perovskite cell.

In any embodiment, the thickness of the indirect contact layer is 0.1-20 nm, optionally, 0.1-10 nm, and even optionally, 0.1-5 nm; and/or, in the indirect contact layer, the molar ratio of the reducing cations to the nickel element is (0.0001-0.2):1; optionally, (0.002-0.05):1; and/or, in the indirect contact layer, in a case that the indirect contact layer includes the doped cations, the molar ratio of the doped cations to the nickel element is (0.0001-0.2):1, optionally, (0.001-0.1):1. In this way, the hole mobility of the hole transport layer as well as the photoelectric conversion efficiency of the perovskite cell are effectively improved, while maintaining good crystallinity in both the indirect contact layer and the non-contact layer.

In any embodiment, a density of each of the direct contact layer, the non-direct contact layer, and the indirect contact layer is independently 1%-100%, optionally, 85%-100%.

In a second aspect, the present application provides a preparation method for the perovskite cell in the first aspect of the present application, and the preparation method includes the following steps:
forming the first electrode layer, the hole transport layer, the perovskite layer, and the second electrode layer which are stacked in sequence;
the hole transport layer includes nickel oxide and the reducing cations.

In the preparation method, the reducing cations are added to the hole transport layer, the reducing cations can reduce the high-valence nickel ions, therefore, the reducing cations can react with the high-valence nickel ions in the hole transport layer to convert the high-valence nickel ions into the low-valence nickel ions, thereby alleviating the degradation of perovskite caused by the reaction of the high-valence nickel ions with a perovskite layer material, improving the long-term stability of the perovskite layer, and prolonging the service life of the perovskite cell.

In any embodiment, the hole transport layer is prepared by the following steps:
preparing a plurality of hole transport monolayers in sequence on the first electrode layer, the plurality of hole transport monolayers being stacked on the first electrode layer, at least the hole transport monolayer in direct contact with the perovskite layer including the reducing cations. Therefore, different cations can be doped into different hole transport monolayers as needed. Further, the reducing cations can reduce the high-valence nickel ions at the interface of the hole transport layer close to the perovskite layer, thus reducing the degradation problem of perovskite caused by deprotonation reaction when the high-valence nickel ions contact the perovskite layer, improving the long-term stability of the perovskite layer, and consequently prolonging the service life of the perovskite cell.

In any embodiment, in the hole transport monolayer close to the perovskite layer, the molar ratio of the reducing cations to nickel element is (0.0001-0.2):1, optionally, (0.002-0.05):1. In this way, the degradation of perovskite can be effectively alleviated, the service life of the perovskite cell can be prolonged, while maintaining good crystallinity in the hole transport layer.

In any embodiment, each hole transport monolayer independently contains or do not contain the doped cations that cause distorting in the lattice of nickel oxide. By doping the hole transport monolayer with the doped cations that cause distorting in the lattice of nickel oxide, defects can be introduced into the nickel oxide crystal, thereby increasing the hole mobility of the hole transport layer, and consequently improving the photoelectric conversion efficiency and the fill factors of the perovskite cell.

In any embodiment, in the hole transport monolayer containing the doped cations, the molar ratio of the doped cations to the nickel element is (0.0001-0.2):1, optionally, (0.001-0.1):1. In this way, the hole mobility of the hole transport layer as well as the photoelectric conversion efficiency of the perovskite cell can be effectively improved, while maintaining good crystallinity in the hole transport layer.

In any embodiment, 2-50 hole transport monolayers are provided, optionally, 4-20 hole transport monolayers are provided.

In any embodiment, the thickness of each hole transport monolayer is 0.1-20 nm, optionally, 0.5-10 nm.

In a third aspect, the present application provides a photovoltaic module, including the perovskite cell in the first aspect of the present application or the perovskite cell prepared by the preparation method in the second aspect of the present application.

In a fourth aspect, the present application provides a photovoltaic system, including the photovoltaic module in the third aspect of the present application.

In a fifth aspect, the present application provides an electrical apparatus, including the photovoltaic system in the fourth aspect of the present application.

In a sixth aspect, the present application provides a power generation apparatus, including the photovoltaic system in the fourth aspect of the present application.

Details of one or more embodiments of this application will be provided in the accompanying drawings and descriptions below. Other features, objectives, and advantages of the present application will become apparent from the specification, drawings, and claims.

### DESCRIPTION OF DRAWINGS

In order to better describe and illustrate the embodiments or examples of the applications disclosed herein, reference may be made to one or more of the figures. The additional details or examples used to describe the drawings should not be considered as limiting the scope of the disclosed applications, currently described embodiments or examples, and any one of currently understood preferred embodiments of these applications. Moreover, in all of the figures, identical parts are represented by identical reference numerals. In the figures:
FIG. 1 is a schematic structural diagram of a perovskite cell according to an embodiment of the present application; and
FIG. 2 is a schematic structural diagram of an electrical apparatus according to an embodiment of the present application.

Reference numerals:
10, perovskite cell; 11, first electrode layer; 12, hole transport layer; 13, perovskite layer; 14, second electrode layer; 121, first hole transport monolayer; 122, second hole transport monolayer; and 123, third hole transport monolayer.

### DETAILED DESCRIPTION

Some embodiments of a perovskite cell in the present application are disclosed in detail below with appropriate reference to the accompanying drawings. However, some unnecessary details may be omitted. For example, there are cases where detailed descriptions of well-known items and repeated descriptions of actually identical structures are omitted. This is to prevent the following description from becoming unnecessarily lengthy and to facilitate the understanding of those skilled in the art. In addition, the accompanying drawings and subsequent descriptions are provided for those skilled in the art to fully understand the present application, and are not intended to limit the subject matter recited in the claims.

In the present application, the "range" is defined in a form of a lower limit and an upper limit, and a given range is defined by selecting a lower limit and an upper limit, which define the boundaries of a particular range. The range defined in this way may include or may not include end values, and may be arbitrarily combined, that is, any lower limit can be combined with any upper limit to form a range. For example, if ranges 60-120 and 80-110 are listed for specific parameters, it is understood that ranges 60-110 and 80-120 are also expected. In addition, if the listed minimum range values are 1 and 2 and if the listed maximum range values are 3, 4, and 5, the following ranges can all be expected: 1-3, 1-4, 1-5, 2-3, 2-4, and 2-5. In the present application, unless otherwise specified, the numerical range "a-b" represents an abbreviated representation of any combination of real numbers between a and b, where a and b are both real numbers. For example, the numerical range "0-5" indicates that all real numbers between "0-5" have been listed herein, and "0-5" is only a shortened representation of these numerical combinations. In addition, when expressing a parameter to be an integer ≥2, it is equivalent to disclosing that the parameter is an integer 2, 3, 4, 5, 6, 7, 8, 9, 10, 11, 12, etc. For example, if a certain parameter is an integer selected from "2-10", it corresponds to listing the integers 2, 3, 4, 5, 6, 7, 8, 9, and 10.

Unless otherwise specified, all embodiments of the present application and optional embodiments may be combined with each other to form a new technical solution.

Unless otherwise particularly stated, all steps in the present application may be performed sequentially or may be performed randomly, and are preferably performed sequentially. For example, the method includes steps (a) and (b), meaning that the method may include steps (a) and (b) performed sequentially, or may include steps (b) and (a) performed sequentially. For example, reference to "the method may further include step (c)" indicates that step (c) may be added to the method in any order, for example, the method may comprise steps (a), (b), and (c), or steps (a), (c), and (b), or steps (c), (a), and (b), etc.

Unless otherwise specifically stated, "including" and "comprising" mentioned in the present application indicate either open inclusion or closed inclusion. For example, the terms "including" and "comprising" may indicate that other components not listed may be further included or comprised, or only the listed components may be included or comprised.

Unless otherwise specifically stated, in the present application, the term "or" is inclusive. For example, the phrase "A or B" means "A, B, or both A and B." Further, the condition "A or B" is satisfied under any one of the following conditions: A is true (or present) and B is false (or absent); A is false (or absent) and B is true (or present); or both A and B are true (or present).

In the present application, unless otherwise stated, A (such as B) means that B is a non-limiting example of A and it is to be understood that A is not limited to B.

The "plurality", "multiple" and the like involved in the present application, unless otherwise specified, refer to a number greater than 2 or equal to 2. For example, "one or more" means one or more than two.

The terms "its combination," "any combination thereof," and "any manner of combination thereof" here include all appropriate combinations of any two or more of the listed items.

Here, the terms "suitable combination mode," "suitable mode," and "any suitable mode" use "suitable" based on enabling the implementation of the technical solutions of the present application.

Here, the terms such as "preferred", "preferable", "more preferable", and "appropriate" are only used for describing implementation modes or embodiments with better effects and should be understood as not limiting the scope of protection of the present application. If a technical solution contains a plurality of instances of "preferred", unless otherwise specified, and provided there are no contradictions or mutual restrictions, each "preferred" should be considered independently.

In the present application, terms such as "further", "even further", "particular" are used for describing purposes and indicate differences in content, but should not be understood as limiting the scope of protection of the present application.

In the present application, the terms such as "first," "second," "third," and "fourth" in the phrases such as "first aspect," "second aspect," "third aspect," and "fourth aspect" are used only for descriptive purposes, and can neither be construed as indicating or implying a relative importance or number, nor be construed as implicitly indicating the importance or number of indicated technical features. Moreover, the terms like "first", "second", "third", and "fourth" are intended only for non-exhaustive enumeration and description, and should be understood as not constituting a closed limitation on quantity.

In the present application, the term "room temperature" generally refers to 4°C-35°C, and may refer to 20°C ± 5°C. In some embodiments of the present application, room temperature refers to 20°C-30°C.

In the present application, for units related to the data range, if a unit is only indicated after the right endpoint, it means that the units for both the left and right endpoints are the same. For example, 3-5 h indicates that the units for the left endpoint "3" and the right endpoint "5" are both h (hour).

In the embodiments of the present application, the weights of relevant ingredients mentioned in the specification can refer not only to the amounts of each component but also to the weight ratios between the components, so, as long as the content of the related components in the specification in the embodiments of the present application is proportionally scaled up or down, it still falls within the scope disclosed in the specification in the embodiments of the present application. Further, the mass mentioned in the specification in the embodiments of the present application can be in µg, mg, g, kg, or other commonly known mass units in the chemical field.

Existing perovskite solar cells typically suffer from poor long-term stability of perovskite layers, resulting in short service lives and severely hindering the industrial application. Therefore, improving the long-term stability of the perovskite layers and prolonging the service lives of the batteries has become one of the important research directions in this field. In order to solve above problems, in the present application, hole transport layers in the perovskite cells are improved, the long-term stability of the perovskite layers are effectively improved, thus prolonging the service lives of the perovskite cells.

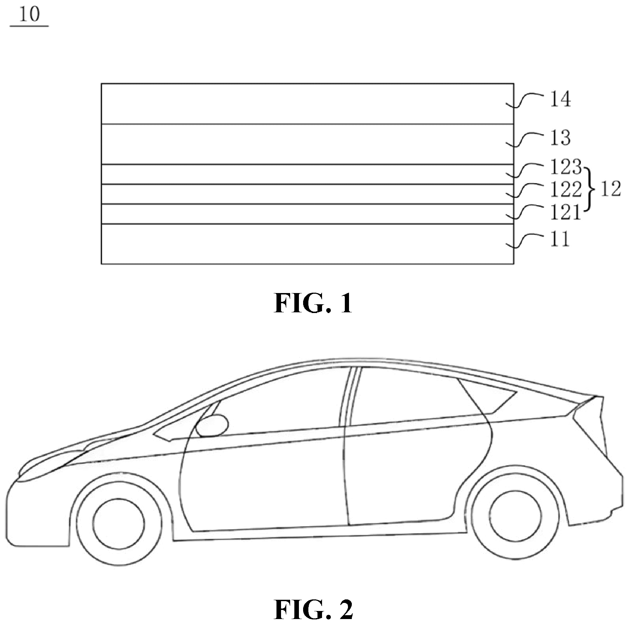

With reference to FIG. 1, in a first aspect, the present application provides a perovskite cell 10, which includes a first electrode layer 11, a hole transport layer 12, a perovskite layer 13, and a second electrode layer 14. The hole transport layer 12 is arranged on the first electrode layer 11, and the hole transport layer 12 includes nickel oxide and reducing cations. The reducing cations can reduce high-valence nickel ions, and a valence of the high-valence nickel ions is greater than or equal to +3; the perovskite layer 13 is arranged on a side of the hole transport layer 12 facing away from the first electrode layer 11; and the second electrode layer 14 is arranged on a side of the perovskite layer 13 facing away from the hole transport layer 12.

In the fabrication process of the perovskite cell 10, the hole transport layer 12 is made of a nickel oxide material (NiOx), which contains divalent nickel ions and high-valence nickel ions with valence greater than or equal to +3; and these high-valence nickel ions belong to Bronsted base and will cause degradation of perovskite due to a deprotonation reaction of the perovskite material when contacting the perovskite layer 13, resulting in poor long-term stability of the perovskite layer 13, and affecting the service life of the perovskite cell 10. The reaction process of degradation of perovskite is shown as follows:

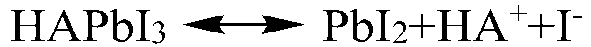

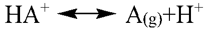

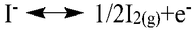

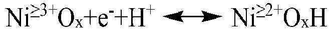

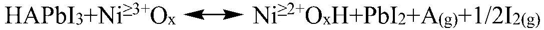

In the perovskite cell 10 in the present application, the reducing cations that can reduce the high-valence nickel ions are added to the hole transport layer 12; and the reducing cations can be subjected to a redox reaction with the high-valence nickel ions in the hole transport layer 12 so as to convert the high-valence nickel ions into low-valence nickel ions (such as Ni²⁺), thereby alleviating the degradation of perovskite, improving the long-term stability of the perovskite layer 13, and consequently prolonging the service life of the perovskite cell 10.

It is to be noted that although the reducing cations that can reduce the high-valence nickel ions are added to the hole transport layer 12 and then react with the high-valence nickel ions so as to be consumed, due to that the perovskites usually contain halide ions (such as iodide ions), the cations, reacting with the high-valence nickel ions, in the part that the hole transport layer 12 is in contact with the perovskite layer 13 will react with the halide ions in the perovskite and be reduced to the reducing cations. That is, the reducing cations can still be detected from the hole transport layer 12 of the perovskite cell 10.

In some embodiments, the reducing cations include lanthanide metal ions. In some specific examples, the lanthanide metal ions include one or more of Eu²⁺, Yb²⁺, Sm²⁺, Ce³⁺, Tb³⁺, or Pr³⁺. The lanthanide metal ions have F orbitals outside atomic nuclei, and the F orbitals are in a half-filled state; the lanthanide metal ions have good reducing performance and can reduce the high-valence nickel ions in the hole transport layer to the low-valence nickel ions, thereby effectively alleviating the degradation of perovskite.

In some embodiments, the concentration of the reducing cations on the side of the hole transport layer 12 facing the perovskite layer 13 is greater than the concentration of the reducing cations on the side of the hole transport layer 12 facing the first electrode layer 11. In the perovskite cell 10, since the high-valence nickel ions on the side of the hole transport layer 12 contacting the perovskite layer 13 will contact the perovskite to cause the degradation of perovskite, the concentration of the reducing cations on the side of the hole transport layer 12 contacting the perovskite layer 13 is greater than the concentration of the reducing cations on the side of the hole transport layer 12 facing the first electrode layer 11, thus the reducing cations are mainly to reduce the high-valence nickel ions in the hole transport layer 12 on the side of the hole transport layer 12 contacting the perovskite layer 13, thereby reducing the content of the high-valence nickel ions and consequently reducing the contact between the high-valence nickel ions and the perovskite material, which can better alleviate the degradation of the perovskite.

In some embodiments, the nickel oxide in the hole transport layer 12 also includes doped cations that can cause distorting in the lattice of the nickel oxide. Because nickel oxide has a low intrinsic mobility, if it is used as the hole transport layer 12 in the perovskite cell 10, the hole mobility is low, resulting in poor photovoltaic conversion efficiency (PCE) and fill factors (FF) of the perovskite cell 10. Therefore, in the present application, the doped cations that can cause distorting in the lattice of nickel oxide are added to the hole transport layer 12, and after the doped cations are added to the lattice of nickel oxide, the difference to the radius of the nickel ions will cause the distorting in lattice of nickel oxide, resulting in defects in the nickel oxide crystal, thereby improving the hole mobility of the hole transport layer 12, and consequently improving the photoelectric conversion efficiency and fill factors of the perovskite cell 10.

In some embodiments, the doped cations include one or more of Li⁺, Cs⁺, Rb⁺, Ag⁺, Mg²⁺, Ca²⁺, Zn²⁺, Sr²⁺, Ba²⁺, Fe²⁺, Fe³⁺, Co²⁺, Co³⁺, Cu⁺, Eu³⁺, Yb³⁺, Sm²⁺, Ce⁴⁺, Tb⁴⁺, Pr⁴⁺, Cu²⁺, or Nd³⁺. There is a difference between the ionic radius of these ions and the ionic radius of the nickel ions in nickel oxide; and by adding these ions the doped cations to the hole transport layer 12, the hole mobility of the hole transport layer 12 can be effectively improved.

In some embodiments, the hole transport layer 12 includes a direct contact layer on the side facing the perovskite layer 13 and a non-direct contact layer on the side away from the perovskite layer 13; the direct contact layer includes nickel oxide and the reducing cations, and the non-direct contact layer includes nickel oxide. By means of above arrangement, the reducing cations can reduce the high-valence nickel ions at the interface of the hole transport layer 12 close to the perovskite layer 13 without excessively affecting the high-valence nickel ions in the hole transport layer 12, thus the problem of degradation of perovskite caused by deprotonation when the high-valence nickel ions at the interface contact the perovskite layer 13 can be reduced, and moreover, the promoting effect of the high-valence nickel ions in the hole transport layer 12 on hole transport cannot be influenced.

In some embodiments, the direct contact layer refers to a portion of the hole transport layer closest to the perovskite layer.

In some embodiments, the non-direct contact layer refers to a portion of the hole transport layer that is at least separated from the perovskite layer by the aforementioned direct contact layer.

In some embodiments, at least 60% by mass of the reducing cations in the hole transport layer 12 are distributed in the direct contact layer; by means of the distribution of at least 60% of the reducing cations in the direct contact layer, the high-valence nickel ions at the interface of the hole transport layer close to the perovskite layer can be reduced without excessively affecting the high-valence nickel ions in the hole transport layer.

It is to be understood that the content of the reducing cations in the direct contact layer can be 60%, 62%, 65%, 68%, 70%, 72%, 75%, 78%, 80%, 82%, 85%, 88%, 90%, 92%, 95%, 98%, or 100% of the total mass of reducing cations in the hole transport layer 12, or any value within the range formed by any two of the above values.

In some embodiments, the thickness of the direct contact layer is 0.1-20 nm; further, the thickness of the direct contact layer is 0.1-10 nm; by controlling the thickness of the direct contact layer within the above range, the reducing cations in the direct contact layer can effectively reduce the high-valence nickel ions at the interface so as to reduce the damage to the material of the perovskite layer 13, while not affecting the promoting effect of the high-valence nickel ions in the hole transport layer 12 on hole transport.

It is to be understood that the thickness of the direct contact layer can be 0.1 nm, 0.5 nm, 0.8 nm, 1 nm, 1.5 nm, 2 nm, 3 nm, 4 nm, 5 nm, 6 nm, 7 nm, 8 nm, 9 nm, 10 nm, 11 nm, 12 nm, 13 nm, 14 nm, 15 nm, 16 nm, 17 nm, 18 nm, 19 nm, 20 nm, or any value within the range formed by any two of the above values.

In some embodiments, the thickness of the direct contact layer is 2-10 nm. In this way, the perovskite cell can simultaneously achieve high initial photoelectric conversion efficiency and long service life, so the overall performance is improved.

In some embodiments, the molar ratio of the reducing cations to the nickel element in the direct contact layer is (0.0001-0.2):1, further, (0.002-0.05):1. By controlling the molar ratio of the reducing cations to the nickel element in the direct contact layer within the above range, the degradation of perovskite can be effectively alleviated and the service life of the perovskite cell 10 can be prolonged. It is to be understood that the molar ratio of the reducing cations to the nickel element in the direct contact layer can be 0.0001:1, 0.0005:1, 0.001:1, 0.002:1, 0.005:1, 0.01:1, 0.02:1, 0.05:1, 0.08:1, 0.1:1, 0.12:1, 0.15:1, 0.18:1, 0.2:1, or any ratio within the range formed by any two of the above ratios.

In some embodiments, the hole transport layer 12 further includes an indirect contact layer which is located between the direct contact layer and the non-direct contact layer, and the indirect contact layer includes nickel oxide and the reducing cations. The indirect contact layer refers to a portion of the hole transport layer located between the direct contact layer and the indirect contact layer. The thickness of the indirect contact layer is 0.1-20 nm, further, optionally, 0.1-10 nm, even further, optionally, 0.1-5 nm. It is to be understood that the thickness of the indirect contact layer can be 0.1 nm, 0.5 nm, 0.8 nm, 1 nm, 2 nm, 3 nm, 5 nm, 6 nm, 8 nm, 10 nm, 12 nm, 13 nm, 15 nm, 16 nm, 18 nm, 20 nm, or any value within the range formed by any two of the above values.

In some embodiments, the hole transport layer 12 further includes the indirect contact layer which is located between the direct contact layer and the non-direct contact layer, and the indirect contact layer includes nickel oxide, the reducing cations, and the doped cations. The thickness of the indirect contact layer is 0.1-20 nm, further, optionally, 0.1-10 nm, even further, optionally, 0.1-5 nm. It is to be understood that the thickness of the indirect contact layer can be 0.1 nm, 0.5 nm, 0.8 nm, 1 nm, 2 nm, 3 nm, 5 nm, 6 nm, 8 nm, 10 nm, 12 nm, 13 nm, 15 nm, 16 nm, 18 nm, 20 nm, or any value within the range formed by any two of the above values.

In some embodiments, in the indirect contact layer, the molar ratio of the reducing cations to the nickel element is (0.0001-0.2):1, further optionally (0.002-0.05):1; the molar ratio of the doped cations to the nickel element is (0.0001-0.2):1, further optionally, (0.001-0.1):1. By means of above arrangement, the hole mobility of the hole transport layer 12 and the photoelectric conversion efficiency of the perovskite cell 10 can be effectively improved, while maintaining good crystallinity in both the indirect contact layer and the non-contact layer.

It is to be understood that the molar ratio of the reducing cations to the nickel element in the indirect contact layer can be 0.0001:1, 0.0005:1, 0.001:1, 0.002:1, 0.005:1, 0.01:1, 0.02:1, 0.05:1, 0.08:1, 0.1:1, 0.12:1, 0.15:1, 0.18:1, 0.2:1, and any two of the above ratios within a certain range; and the molar ratio of the doped cations to the nickel element can be any value within the range of 0.0001:1, 0.0005:1, 0.001:1, 0.002:1, 0.005:1, 0.01:1, 0.02:1, 0.05:1, 0.08:1, 0.1:1, 0.12:1, 0.15:1, 0.18:1, 0.2:1, and any ratio within the range formed by any two of the above ratios.

In a second aspect, the present application provides a preparation method for the perovskite cell 10 in the first aspect of the present application, and the method includes the following steps S100 to S400:
Step S100: Provide the first electrode layer 11.

The first electrode layer 11 can serve as a substrate on which other functional layers of the perovskite cell 10 are formed.

In some embodiments, the first electrode layer 11 can be made of transparent conductive glass. The transparent conductive glass includes one or more of fluorine-doped tin oxide (FTO), indium tin oxide (ITO), tungsten-doped indium oxide (IWO), aluminum-doped zinc oxide (AZO), boron-doped zinc oxide (BZO), or indium zinc oxide (IZO).

Step S200: Prepare the hole transport layer 12 on the first electrode layer 11.

The first electrode layer 11 serves as the substrate, and the hole transport layer 12 can be prepared on the first electrode layer 11 by a magnetron sputtering or solution method. The hole transport layer 12 includes nickel oxide and the reducing cations.

In the preparation process of the perovskite cell 10, the high-valence nickel ions with the valence greater than or equal to +3 are usually distributed in the hole transport layer 12, and the high-valence nickel ions in the hole transport layer 12 are conducive to hole transport, but as the high-valence nickel ions at the interface of the hole transport layer 12 contacting the perovskite layer 13 make contact with the perovskite layer 13, the deprotonation of the perovskite will occur, which causes the degradation of perovskite, resulting in influence on the long-term stability of the perovskite layer 13 and the service life of the perovskite cell 10. The reducing cations that can reduce the high-valence nickel ions are added to the hole transport layer 12, and the reducing cations can be subjected to the redox reaction with the high-valence nickel ions in the hole transport layer 12 so as to convert the high-valence nickel ions into the low-valence nickel ions (such as Ni²⁺), thereby alleviating the degradation of perovskite, improving the long-term stability of the perovskite layer 13, and consequently prolonging the service life of the perovskite cell 10.

In some embodiments, the reducing cations include lanthanide metal ions. Specifically, the lanthanide metal ions include one or more of Eu²⁺, Yb²⁺, Sm²⁺, Ce³⁺, Tb³⁺, or Pr³⁺. The lanthanide metal ions have F orbitals outside atomic nuclei, and the F orbitals are in a half-filled state; the lanthanide metal ions have good reducing performance and can reduce the high-valence nickel ions in the hole transport layer 12 to the low-valence nickel ions, thereby effectively alleviating the degradation of perovskite.

In some embodiments, the hole transport layer 12 also includes the doped cations that can cause distorting in the lattice of nickel oxide. Nickel oxide has a low intrinsic mobility, which results in poor photoelectric conversion efficiency and fill factor in the perovskite cell 10 using nickel oxide as the hole transport layer 12. In the present application, the doped cations that can cause distorting in the lattice of nickel oxide are added during the preparation of the hole transport layer 12, and after the doped cations are added to the lattice of nickel oxide, the difference to the radius of the nickel ions will cause the distorting in the lattice of nickel oxide, resulting in defects in the nickel oxide crystal, thereby improving the hole mobility of the hole transport layer 12, and consequently improving the photoelectric conversion efficiency and fill factors of the perovskite cell 10.

In some embodiments, the doped cations include one or more of Li⁺, Cs⁺, Rb⁺, Ag⁺, Mg²⁺, Ca²⁺, Zn²⁺, Sr²⁺, Ba²⁺, Fe²⁺, Fe³⁺, Co²⁺, Co³⁺, Cu⁺, Eu³⁺, Yb³⁺, Sm²⁺, Ce⁴⁺, Tb⁴⁺, Pr⁴⁺, Cu²⁺, or Nd³⁺. There is a difference between the ionic radius of these ions and the ionic radius of the nickel ions in nickel oxide; and by adding these ions the doped cations to the hole transport layer 12, the hole mobility of the hole transport layer 12 can be effectively improved.

In some embodiments, in the hole transport layer 12, multilayer hole transport monolayers are formed on the first electrode layer 11 by magnetron sputtering with repeated cyclic coating processes, and the multilayer hole transport monolayers are stacked on the first electrode layer 11 to form the hole transport layer 12. Each hole transport monolayer is prepared by magnetron sputtering with repeated cyclic coating processes, which facilitates the doping of the reducing cations and the doped cations at different positions in the hole transport layer 12.

In some embodiments, during depositing each hole transport monolayer by magnetron sputtering, the reducing cations are doped into the hole transport monolayer of the hole transport monolayer 12 close to the perovskite layer 13. Since the high-valence nickel ions in the hole transport layer 12 are conducive to hole transport, only the high-valence nickel ions at the interface of the hole transport layer 12 contacting the perovskite layer 13 will cause deprotonation reaction of perovskite, resulting in degradation of perovskite; by doping the reducing cations in the hole transport monolayer at the interface of the hole transport layer 12 contacting the perovskite layer 13, the degradation of perovskite can be better alleviated, and the hole transport layer 12 achieves better hole transport performance.

In one specific example, the hole transport layer 12 is formed by the following single-target magnetron sputtering method:
the single-target magnetron sputtering method is carried out to deposit the direct contact layer, the indirect contact layer, and the non-direct contact layer; the direct contact layer refers to the hole transport monolayer that is in direct contact with the perovskite layer 13; the indirect contact layer refers to the hole transport monolayer that is separated from the perovskite layer 13 only by the direct contact layer; and the non-direct contact layer is any hole transport monolayer other than the direct contact layer and the indirect contact layer.

The first hole transport monolayer 121 is deposited by magnetron sputtering on the first electrode layer 11 as the non-direct contact layer, and the doped cations can be selectively introduced or are not introduced into a nickel oxide target selected in the preparation of the non-direct contact layer, so that the prepared non-direct contact layer contains or does not contain a certain amount of doped cations; the second hole transport monolayer 122 is deposited by magnetron sputtering on the non-direct contact layer as the indirect contact layer, and the reducing cations and the doped cations can be selectively introduced or are not introduced into the nickel oxide target selected in the preparation of the indirect contact layer, so that the prepared indirect contact layer contains or does not contain a certain amount of reducing cations and/or doped cations; and then, the third hole transport monolayer 123 is deposited by magnetron sputtering on the indirect contact layer as the direct contact layer, the reducing cations are introduced into the nickel oxide target selected in the preparation of the direct contact layer, so that the prepared direct contact layer contains a certain amount of reducing cations.

It is to be noted that since the indirect contact layer is in contact with the direct contact layer and the direct contact layer contains the reducing cations, based on factors such as ion diffusion, even if the reducing cations are not introduced into the indirect contact layer during preparation, a certain amount of reducing cations will still exist in the indirect contact layer of the final perovskite cell 10.

In some embodiments, the direct contact layer, the indirect contact layer, and the non-contact layer are all prepared by radio frequency sputtering. Working gases used in the radio frequency sputtering process are argon and oxygen, and the ratio of oxygen flow rate/ (oxygen flow rate + argon flow rate) is (0.001-0.5):1. The temperature of a deposition stage during sputtering is 20°C-300°C. A vacuum level of a reaction chamber during sputtering is 1.0⁻³Pa-1.0⁻¹Pa. The sputtering power density is 5W/cm²-50W/cm². The deposition costs 5-180 s.

It is to be understood that the ratio of oxygen flow rate/ (oxygen flow rate + argon flow rate) can be 0.001:1, 0.005:1, 0.008:1, 0.01:1, 0.015:1, 0.02:1, 0.05:1, 0.08:1, 0.1:1, 0.15:1, 0.2:1, 0.25:1, 0.3:1, 0.35:1, 0.4:1, 0.45:1, 0.5:1, and any ratio within the range formed by any two of the above ratios. The temperature of the deposition stage can be 20°C, 50°C, 80°C, 100°C, 120°C, 140°C, 150°C, 160°C, 180°C, 200°C, 220°C, 240°C, 250°C, 260°C, 280°C, 300°C, or any value within the range formed by any two of the above values. The vacuum level of the reaction chamber can be 1.0⁻³Pa, 5.0⁻³Pa, 8.0⁻³Pa, 1.0⁻²Pa, 5.0⁻²Pa, 8.0⁻²Pa, 1.0⁻¹Pa, or any value within the range formed by any two of the above values. The sputtering power density can be 5 W/cm², 8 W/cm², 10 W/cm², 12 W/cm², 14 W/cm², 15 W/cm², 16 W/cm², 18 W/cm², 20 W/cm², 22 W/cm², 24 W/cm², 25 W/cm², 26 W/cm², 28 W/cm², 30 W/cm², 32 W/cm², 34 W/cm², 35 W/cm², 36 W/cm², 38 W/cm², 40 W/cm², 42 W/cm², 44 W/cm², 45 W/cm², 46 W/cm², 48 W/cm², 50 W/cm², and any value within the range formed by any two of the above values. The deposition time can be 5 s, 10 s, 20 s, 30 s, 40 s, 50 s, 60 s, 70 s, 80 s, 90 s, 100 s, 110 s, 120 s, 130 s, 140 s, 150 s, 160 s, 170 s, 180 s, or any value within the range formed by any two of the above values.

In some embodiments, in the direct contact layer and indirect contact layer which are doped with the reducing cations, the molar ratio of the reducing cations to the nickel element is (0.0001-0.2):1, optionally, (0.002-0.05):1. By controlling the molar ratio of the reducing cations to the nickel element within the above range, the degradation of perovskite can be effectively alleviated and the service life of perovskite cell 10 can be prolonged, while maintaining good crystallinity in both the direct contact layer and the indirect contact layer. It is to be understood that the molar ratio of the reducing cations to the nickel element can be 0.0001:1, 0.0006:1, 0.002:1, 0.008:1, 0.01:1, 0.015:1, 0.02:1, 0.03:1, 0.04:1, 0.05:1, 0.06:1, 0.07:1, 0.08:1, 0.09:1, 0.1:1, 0.12:1, 0.14:1, 0.16:1, 0.18:1, 0.2:1, or any value within the range formed by any two of the above values.

In some embodiments, in the indirect contact layer and the non-direct contact layer which are doped with the doped cations, the molar ratio of the doped cations to the nickel element is (0.0001-0.2):1, optionally, (0.001-0.1):1. By controlling the molar ratio of the doped cations to the nickel element within the above range, the hole mobility of the hole transport layer 12 and the photoelectric conversion efficiency of the perovskite cell 10 can be effectively improved, while maintaining good crystallinity in both the indirect contact layer and the non-direct contact layer. It is to be understood that the molar ratio of the doped cations to the nickel element can be 0.0001:1, 0.0005:1, 0.001:1, 0.005:1, 0.01:1, 0.02:1, 0.03:1, 0.04:1, 0.05:1, 0.06:1, 0.08:1, 0.1:1, 0.12:1, 0.15:1, 0.18:1, 0.2:1, and any value within the range formed by any two of the above values.

Specifically, there can be 1-50 hole transport monolayers, optionally, 4-20 hole transport monolayers in the hole transport layer 12. Based on the effect of magnetron sputtering, the thickness of each hole transport layer is 0.1-20 nm, optionally, 0.5-10 nm. Based on the effect of magnetron sputtering, the density of the hole transport monolayers is 1%-100%, optionally, 85%-100%. It is to be understood that the number of the hole transmission single layers can be 1, 4, 6, 8, 10, 12, 14, 15, 16, 18, 20, 25, 28, 30, 32, 35, 38, 40, 42, 45, 48, 50, or any integer value within the range formed by any two of the above values. The thickness of each hole transport monolayer can be 0.1 nm, 0.5 nm, 1 nm, 2 nm, 4 nm, 5 nm, 6 nm, 8 nm, 10 nm, 12 nm, 14 nm, 15 nm, 16 nm, 18 nm, 20 nm, or any value within the range formed by any two of the above values. The density of each hole transport monolayer can be 1%, 5%, 8%, 10%, 12%, 15%, 18%, 20%, 25%, 30%, 35%, 40%, 45%, 50%, 55%, 60%, 65%, 70%, 75%, 80%, 85%, 90%, 95%, 100%, or any value within the range formed by any two of the above values.

In some embodiments, the hole transport layer 12 is formed by the following multi-target magnetron co-sputtering method:
the first hole transport monolayer 121 is deposited by magnetron sputtering on the first electrode layer 11 as the non-direct contact layer, the doped cations can be selectively introduced or are not introduced into the nickel oxide target selected in the preparation of the non-direct contact layer, so that the prepared non-direct contact layer contains or does not contain a certain amount of doped cations; the second hole transport monolayer 122 is deposited by magnetron sputtering on the indirect contact layer as the indirect contact layer, both the nickel oxide target containing the doped cations and an AOₙ target can be used simultaneously in the preparation of the indirect contact layer, in which, AOₙ represents an oxide corresponding to the reducing cations, and n represents the number of oxygen atoms; the prepared indirect contact layer contains a certain amount of reducing cations and doped cations; and then, the third hole transport monolayer 123 is deposited by magnetron sputtering on the indirect contact layer as the direct contact layer, and both the nickel oxide target and the AOₙ target can be used simultaneously in the preparation of the direct contact layer, so that the prepared direct contact layer contains a certain amount of reducing cations.

In some embodiments, the direct contact layer, the indirect contact layer, and the non-direct contact layer are all prepared by the radio frequency sputtering method. The working gases used in the radio frequency sputtering process are argon and oxygen, and the ratio of oxygen flow rate/ (oxygen flow rate + argon flow rate) is (0.001-0.5):1. The temperature of the deposition stage during co-sputtering is 20-300°C. The vacuum level of the reaction chamber during co-sputtering is 1.0⁻³Pa-1.0⁻¹Pa. The power density of the nickel oxide target doped with the doped cations during co-sputtering is 5W/cm²-50W/cm². The power density of the AOₙ target during co-sputtering is 2W/cm²-40W/cm². The deposition costs 5-180 s.

It is to be understood that the ratio of oxygen flow rate/ (oxygen flow rate + argon flow rate) can be 0.001:1, 0.005:1, 0.008:1, 0.01:1, 0.015:1, 0.02:1, 0.05:1, 0.08:1, 0.1:1, 0.15:1, 0.2:1, 0.25:1, 0.3:1, 0.35:1, 0.4:1, 0.45:1, 0.5:1, and any ratio within the range formed by any two of the above ratios. The temperature of the deposition stage can be 20°C, 50°C, 80°C, 100°C, 120°C, 140°C, 150°C, 160°C, 180°C, 200°C, 220°C, 240°C, 250°C, 260°C, 280°C, 300°C, or any value within the range formed by any two of the above values. The vacuum level of the reaction chamber can be 1.0⁻³Pa, 5.0⁻³Pa, 8.0⁻³Pa, 1.0⁻²Pa, 5.0⁻²Pa, 8.0⁻²Pa, 1.0⁻¹Pa, or any value within the range formed by any two of the above values. The power density of the nickel oxide target doped with the doped cations during co-sputtering can be 5 W/cm², 8 W/cm², 10 W/cm², 12 W/cm², 14 W/cm², 15 W/cm², 16 W/cm², 18 W/cm², 20 W/cm², 22 W/cm², 24 W/cm², 25 W/cm², 26 W/cm², 28 W/cm², 30 W/cm², 32 W/cm², 34 W/cm², 35 W/cm², 36 W/cm², 38 W/cm², 40 W/cm², 42 W/cm², 44 W/cm², 45W/cm², 46 W/cm², 48 W/cm², 50 W/cm², and any value within the range formed by any two of the above values. The power density of the AOₙ target during co-sputtering can be 2 W/cm², 5 W/cm², 10 W/cm², 15 W/cm², 20 W/cm², 25 W/cm², 30 W/cm², 35 W/cm², 40 W/cm², or any value within the range formed by any two of the above values. The deposition time can be 5 s, 10 s, 20 s, 30 s, 40 s, 50 s, 60 s, 70 s, 80 s, 90 s, 100 s, 110 s, 120 s, 130 s, 140 s, 150 s, 160 s, 170 s, 180 s, or any value within the range formed by any two of the above values.

In some embodiments, in the direct contact layer and indirect contact layer which are doped with the reducing cations, the molar ratio of the reducing cations to the nickel element is (0.0001-0.2):1, optionally, (0.002-0.05):1. By controlling the molar ratio of the reducing cations to the nickel element within the above range, the degradation of perovskite can be effectively alleviated, and the service life of perovskite solar cells can be prolonged, while maintaining good crystallinity in both the direct contact layer and the indirect contact layer. It is to be understood that the molar ratio of the reducing cations to the nickel element can be 0.0001:1, 0.0006:1, 0.002:1, 0.008:1, 0.01:1, 0.015:1, 0.02:1, 0.03:1, 0.04:1, 0.05:1, 0.06:1, 0.07:1, 0.08:1, 0.09:1, 0.1:1, 0.12:1, 0.14:1, 0.16:1, 0.18:1, 0.2:1, or any value within the range formed by any two of the above values.

In some embodiments, in the indirect contact layer and the non-direct contact layer which are doped with the doped cations, the molar ratio of the doped cations to the nickel element is (0.0001-0.2):1, optionally, (0.001-0.1):1. By controlling the molar ratio of the doped cations to the nickel element within the above range, the hole mobility of the hole transport layer 12 and the photoelectric conversion efficiency of the perovskite cell 10 can be effectively improved, while maintaining good crystallinity in both the indirect contact layer and the non-direct contact layer. It is to be understood that the molar ratio of the doped cations to the nickel element can be 0.0001:1, 0.0005:1, 0.001:1, 0.005:1, 0.01:1, 0.02:1, 0.03:1, 0.04:1, 0.05:1, 0.06:1, 0.08:1, 0.1:1, 0.12:1, 0.15:1, 0.18:1, 0.2:1, and any value within the range formed by any two of the above values.

Specifically, there can be 1-30 hole transport monolayers, optionally, 4-20 hole transport monolayers in the hole transport layer 12. Based on the effect of magnetron sputtering, the thickness of the hole transport monolayers is 0.2-20 nm, optionally, 1-10 nm. Based on the effect of magnetron sputtering, the density of the hole transport monolayers is 1%-100%, optionally, 85%-100%.

It is to be understood that the thickness of the second hole transport monolayer 122 serving as the indirect contact layer is 0.1-20 nm, further optionally, 0.1-10 nm, and even further optionally, 0.1-5 nm; the thickness of the third hole transport monolayer 123 serving as the direct contact layer is 0.1-20 nm, further optionally, 0.1-10 nm, and even further optionally, 0.1-5 nm. The total number of the hole transport monolayers can be 1, 4, 6, 8, 10, 12, 14, 15, 16, 18, 20, 25, 28, 30, or any integer value within the range formed by any two of the above values. The thickness of each hole transport monolayer can be 0.2 nm, 0.5 nm, 1 nm, 2 nm, 4 nm, 5 nm, 6 nm, 8 nm, 10 nm, 12 nm, 14 nm, 15 nm, 16 nm, 18 nm, 20 nm, or any value within the range formed by any two of the above values. The density of each hole transport monolayer can be 1%, 5%, 8%, 10%, 12%, 15%, 18%, 20%, 25%, 30%, 35%, 40%, 45%, 50%, 55%, 60%, 65%, 70%, 75%, 80%, 85%, 90%, 95%, 100%, or any value within the range formed by any two of the above values.

Step S300: Prepare a perovskite layer 13 on the surface of the hole transport layer 12 facing away from the first electrode layer 11.

After the hole transport layer 12 is formed on the first electrode layer 11, the perovskite layer 13 is prepared on the surface of the hole transport layer 12 facing away from the first electrode layer 11 as a light-absorbing layer of the perovskite cell 10.

In some embodiments, the material of the perovskite layer 13 can include one or more of ABX₃ or A₂CDX₆, in which, A includes one or more of organic cations, Li⁺, Na⁺, K⁺, Rb⁺, or Cs⁺; B includes Pb²⁺, Sn²⁺, Be²⁺, Mg²⁺, Ca²⁺, Sr²⁺, Ba²⁺, Zn²⁺, Ge²⁺, Fe²⁺, Co²⁺, Cu²⁺, or Ni²⁺; C includes one or more of Cs⁺, Ag⁺, K⁺, or Ru⁺; D includes one or more of Bi³⁺, Ni³⁺, Fe³⁺, Cu³⁺, Sb³⁺, or In³⁺; X includes one or more of Br⁻ or I⁻. For example, the material of the perovskite layer 13 can be one or more of CH₃NH₃PbI₃, CH₃NH₃SnI₃, CH₃NH₃PbI₂Br, or CH₃NH₃Pb(I₁₋ₓBrₓ)₃ (0<x<1).

Step S400: Prepare a second electrode layer 14 on the side of the perovskite layer 13 facing away from the hole transport layer 12.

After the perovskite layer 13 is formed, the second electrode layer 14 can be prepared on the surface of the perovskite layer 13 facing away from the hole transport layer 12 by a vacuum thermal evaporation coating process, thereby forming the perovskite cell 10.

In some embodiments, the material of the second electrode layer 14 can include one or more of silver, copper, carbon, gold, aluminum, indium tin oxide, tungsten-doped indium oxide, aluminum-doped zinc oxide, boron-doped zinc oxide, or indium zinc oxide.

In some embodiments, an electron transport layer can also be arranged between the perovskite layer 13 and the second electrode layer 14 for transporting electrons and inhibiting electron backflow. The material of the electron transport layer includes at least one selected from the group consisting of imide compounds, quinone compounds, fullerenes and derivatives thereof, metal oxides, semiconductor oxides, titanates, fluorides and derivatives thereof, and materials obtained by doping or passivation. By way of example, the imide compounds include at least one selected from the group consisting of phthalimide, succinimide, N-bromosuccinimide, glutarimide, or maleimide. By way of example, the quinone compounds include at least one selected from the group consisting of benzoquinone, naphthoquinone, phenanthrenequinone, or anthraquinone. By way of example, the fullerenes and derivatives thereof include at least one selected from the group consisting of fullerene C₆₀, fullerene C₇₀, PCBM ([6,6]-phenyl-C₆₁-methyl butyrate), and [6,6]-phenyl-C₇₁methyl butyrate (PC₇₁BM). By way of example, the metal elements in the metal oxides include at least one selected from the group consisting of Mg, Cd, Zn, In, Pb, W, Sb, Bi, Hg, Ti, Ag, Mn, Fe, V, Sn, Zr, Sr, Ga, and Cr, optionally, the metal oxides include at least one selected from the group consisting of tin oxide (SnO₂), zinc oxide (ZnO), and titanium oxide (TiO₂). By way of example, the semiconductor oxides include silicon oxide. By way of example, the titanates include at least one selected from the group consisting of strontium titanate and calcium titanate. By way of example, the fluorides include at least one selected from the group consisting of lithium fluoride and calcium fluoride.

In some embodiments, the perovskite cell 10 can also include functional layers such as a barrier layer and a passivation layer; the barrier layer includes a hole blocking layer or an electron blocking layer; and the passivation layer is configured to passivate perovskite interface defects.

In some embodiments, the perovskite cell 10 can also be a laminated cell containing the perovskite cell, and the laminated perovskite cell includes, but is not limited to, a perovskite-perovskite laminated cell, a perovskite-crystalline silicon laminated cell, a perovskite-heterojunction laminated cell, etc.

In a third aspect, the present application provides a photovoltaic module, including the perovskite cell 10 in the first aspect of the present application or the perovskite cell 10 prepared by the preparation method in the second aspect of the present application. The photovoltaic module in the present application employing the perovskite cell 10 in the present application has a long service life.

The photovoltaic module includes one or more perovskite cells 10, which can be selected according to specific application scenarios; further, the photovoltaic module includes a plurality of perovskite cells 10 which are connected in series or in parallel to form a cell strip.

In some embodiments, the photovoltaic module further includes a photovoltaic glass layer, adhesive layers, and a backsheet.

The adhesive layers are arranged on two surfaces of the cell strip, the backsheet is arranged on the surface of the adhesive layer away from the cell strip, and the photovoltaic glass layer is arranged on the surface of the adhesive layer away from the cell strip.

The photovoltaic glass layer and the backsheet are configured to protect the perovskite cell 10, and have the functions of sealing, insulation and waterproofing; and the adhesive layers play the role of adhering the photovoltaic glass layer to the cell strip and bonding the backsheet to the cell strip.

Optionally, the photovoltaic glass layer is made of tempered glass, the backsheet is made of TPT (polyvinyl fluoride) or TPE (thermoplastic elastomer), and the adhesive layers are made of EVA (polyethylene-polyvinyl acetate copolymer).

Further, the photovoltaic module further includes a junction box and an outer frame.

The junction box is configured to protect a power generation system of the whole photovoltaic module, and it serves as a current transfer station; in case of short circuit in the cell strip, the junction box will automatically disconnect the short-circuited cell string.

The outer frame serves to support and protect the entire photovoltaic module. The frame can be made of an aluminum alloy material, which has excellent strength and corrosion resistance.

Further, silica gel is used for bonding and sealing the connections between the frame and other sites of the photovoltaic module. The photovoltaic module can convert solar energy into electrical energy, which can then be stored in storage batteries or push the load to work.

In some embodiments, the photovoltaic module is a solar panel.

In a fourth aspect, the present application provides a photovoltaic system, including the photovoltaic module in the third aspect of the present application.

In the photovoltaic system, the perovskite cell 10 in the photovoltaic module is utilized to directly convert solar radiation energy into electrical energy, the efficiency is high, and the stability is good; and further, the photovoltaic system is a photovoltaic power generation system.

The photovoltaic module is a core component of the photovoltaic power generation system; the photovoltaic system includes one or more photovoltaic modules, which can be selected according to specific application scenarios; and further, if the photovoltaic system includes a plurality of photovoltaic modules, the plurality of photovoltaic modules form a photovoltaic array.

The photovoltaic system can be an independent photovoltaic power generation system or a grid-connected photovoltaic power generation system.

The independent photovoltaic power generation system includes the photovoltaic array, a battery pack, a charging controller, a power electronic converter (inverter), and a load. The working principle is that the solar radiation energy is converted into electrical energy by the photovoltaic array, and then converted by the power electronic converter to supply power to the load, meanwhile, the excess electrical energy is stored in a form of chemical energy in the energy storage device after passing through the charging controller; and therefore, in a case of insufficient sunlight, the energy stored in the battery can be converted into 220 V, 50 Hz AC power for AC loads by passing through the power electronic inverter, a filter, and the power frequency step-up transformer.

The grid-connected photovoltaic power generation system includes the photovoltaic array, a high-frequency DC/DC boost circuit, the power electronic converter (inverter), and system monitor. Its working principle is that the solar radiation energy is converted by the photovoltaic array, then converted into high-voltage direct current by the high-frequency DC converter, and then inverted by the power electronic inverter to output a sinusoidal alternating current that is in phase with the grid voltage.

The two photovoltaic power generation systems mentioned above each have related characteristics and can be selected according to the specific application scenario.

With reference to FIG. 2, in a fifth aspect, the present application provides an electrical apparatus, including the photovoltaic system in the fourth aspect of the present application.

In some embodiments, the electrical apparatus is a common device including the solar cell in the present application, such as in the fields of communications, transportation, industry and agriculture, and lighting. The electrical apparatus may include, for example, satellites, communication devices, traffic lights, lighthouses, wireless telephone booths, monitoring devices in the oil drilling field, power systems, camping lights, electric vehicles, electronic device chargers, and building curtain walls.

In a sixth aspect, the present application provides a power generation apparatus, including the photovoltaic system in the fourth aspect of the present application. It is to be understood that in the power generation apparatus, the photovoltaic system is the photovoltaic power generation system.

The embodiments of the present application are illustrated below. The embodiments described below are exemplary and are provided only to explain the present application, and should not be construed as limiting the present application. If the specific technology or conditions are not indicated in the embodiments, the technology or conditions described in the literature in the art or in accordance with the product specification shall be followed. If the manufacturer of the reagent or instrument is not indicated, it is a conventional product that can be obtained through commercial purchase.

Example 1:
1) A set of FTO conductive glass with a specification of 10cm*10cm was collected; a laser marking machine was utilized to etch away 0.5cm area on both sides of the FTO conductive glass; after cleaning with a cleaning agent, the FTO conductive glass was subjected to ultrasonic treatment with deionized water, ethanol and acetone for 10 min in sequence; and after ultrasonic treatment, the FTO conductive glass was blown and dried with nitrogen gas for use.
2) The dried FTO conductive glass was used as the first electrode layer, and a magnetron sputtering method was carried out to prepare three first hole transport monolayers with each layer having a thickness of 3 nm as the non-direct contact layers on the FTO conductive glass, then prepare one second hole transport monolayer with a thickness of 3 nm as the indirect contact layer, and finally, prepare one third hole transport monolayer with a thickness of 3 nm as the direct contact layer.
   In the non-direct contact layer, the nickel oxide target containing the doped cation Li⁺ was used, and the molar ratio of Li⁺ to the nickel element was 0.02:1; in the indirect contact layer, the nickel oxide target containing the reducing cation Eu²⁺ and the doped cation Li⁺ was used, the molar ratio of Eu²⁺ to the nickel element was 0.005:1, and the molar ratio of Li⁺ to the nickel element is 0.0001:1; and in the direct contact layer, the nickel oxide target containing reducing cation Eu²⁺ was used, and the molar ratio of Eu²⁺ to the nickel element was 0.005:1. The working gas used in the sputtering process was a mixture of argon and oxygen, with the ratio of oxygen flow rate to (oxygen flow rate + argon flow rate) being 2:300. The temperature of the deposition stage was controlled to be 100°C-150°C during sputtering. The vacuum level of the reaction chamber during sputtering was controlled to be 1.0*10⁻²Pa-1.0*10⁻¹Pa. The sputtering power density was 10 W/cm². The deposition time for each layer was 20 s.
3) After laser marking, the FTO conductive glass deposited with the nickel oxide hole transport layer was placed in an ultrasonic cleaning apparatus for cleaning for 1 min, and then dried at 100°C for 10 min. A Cs_{0.1}FA_{0.85}MA_{0.05}PbI_{2.7}Br_{0.3} perovskite film with a thickness of about 500 nm was coated on the surface of the nickel oxide hole transport layer facing away from the FTO conductive glass; after continuously blowing the film surface with an air knife for 30 s, the film was transferred to a heating stage and annealed at 100°C for 10 min, so as to form the perovskite layer.
4) A vacuum thermal evaporation coating process was carried out to perform vapor deposition at 1*10⁻⁶Torr on C₆₀ with a thickness of 50 nm, BCP with a thickness of 20 nm, and an Cu electrode with a thickness of 80 nm in sequence; and after laser scribing, vapor deposition was continued on the Cu electrode with a thickness of 100 nm.
5) By means of laser marking, large-area perovskite devices were connected in series, thus completing the fabrication of perovskite cell.

### Example 2:

This example is basically the same as the Example 1, except that the molar ratio of the doped cation Li⁺ to the nickel element is 0.001:1 in the non-direct contact layer and the indirect contact layer of the hole transport layer.

### Example 3:

This example is basically the same as the Example 1, except that the molar ratio of the doped cation Li⁺ to the nickel element is 0.02:1 in the non-direct contact layer and the indirect contact layer of the hole transport layer.

### Example 4:

This example is basically the same as the Example 1, except that the molar ratio of the doped cation Li⁺ to the nickel element is 0.1:1 in the non-direct contact layer and the indirect contact layer of the hole transport layer.

### Example 5:

This example is basically the same as the Example 1, except that the molar ratio of the doped cation Li⁺ to the nickel element is 0.15:1 in the non-direct contact layer and the indirect contact layer of the hole transport layer.

### Example 6:

This example is basically the same as the Example 1, except that the molar ratio of the doped cation Li⁺ to the nickel element is 0.2:1 in the non-direct contact layer and the indirect contact layer of the hole transport layer.

### Example 7:

This example is basically the same as the Example 1, except that the molar ratio of the reducing cation Eu²⁺ to the nickel element is 0.0001:1 in the indirect contact layer and the direct contact layer of the hole transport layer.

### Example 8:

This example is basically the same as the Example 1, except that the molar ratio of the reducing cation Eu²⁺ to the nickel element is 0.002:1 in the indirect contact layer and the direct contact layer of the hole transport layer.

### Example 9:

This example is basically the same as the Example 1, except that the molar ratio of the reducing cation Eu²⁺ to the nickel element is 0.05:1 in the indirect contact layer and the direct contact layer of the hole transport layer.

### Example 10:

This example is basically the same as the Example 1, except that the molar ratio of the reducing cation Eu²⁺ to the nickel element is 0.1:1 in the indirect contact layer and the direct contact layer of the hole transport layer.

### Example 11:

This example is basically the same as the Example 1, except that the molar ratio of the reducing cation Eu²⁺ to the nickel element is 0.2:1 in the indirect contact layer and the direct contact layer of the hole transport layer.

### Example 12:

This example is basically the same as the Example 1, except that: in the indirect contact layer and the direct contact layer of the hole transport layer, the reducing cation is Yb²⁺, and the molar ratio of Yb²⁺ to the nickel element is 0.008:1; and in the non-direct contact layer and the indirect contact layer, the doped cation is Mg²⁺, and the molar ratio of Mg²⁺ to the nickel element is 0.015:1.

### Example 13:

This example is basically the same as the Example 12, except that the molar ratio of the doped cation Mg²⁺ to the nickel element is 0.12:1 in the non-direct contact layer and the indirect contact layer of the hole transport layer.

### Example 14:

This example is basically the same as the Example 12, except that the molar ratio of the reducing cation Yb²⁺ to the nickel element is 0.1:1 in the indirect contact layer and the direct contact layer of the hole transport layer.

### Example 15:

This example is basically the same as the Example 1, except that: in the indirect contact layer and the direct contact layer of the hole transport layer, the reducing cation is Ce³⁺, and the molar ratio of Ce³⁺ to the nickel element is 0.006:1; and in the non-direct contact layer and the indirect contact layer, the doped cation is Sr²⁺, and the molar ratio of Sr²⁺ to the nickel element is 0.05:1.

### Example 16:

This example is basically the same as the Example 15, except that the molar ratio of the doped cation Sr²⁺ to the nickel element is 0.15:1 in the non-direct contact layer and the indirect contact layer of the hole transport layer.

### Example 17:

This example is basically the same as the Example 15, except that the molar ratio of the reducing cation Ce³⁺ to the nickel element is 0.1:1 in the indirect contact layer and the direct contact layer of the hole transport layer.

### Example 18:

This example is basically the same as the Example 1, except that in step 2), the dried FTO conductive glass is used as the first electrode layer, the magnetron sputtering method is utilized to prepare three first hole transport monolayers with each layer having a thickness of 3 nm as the non-direct contact layers on the FTO conductive glass, then prepare one second hole transport monolayer with a thickness of 3 nm as the indirect contact layer, and finally prepare one third hole transport monolayer with a thickness of 2 nm as the direct contact layer; and the doping materials and ratios of each layer are the same as in the Example 1.

### Example 19:

This example is basically the same as the Example 1, except that in step 2), the dried FTO conductive glass is used as the first electrode layer, the magnetron sputtering method is utilized to prepare three first hole transport monolayers with each layer having a thickness of 3 nm as the non-direct contact layers on the FTO conductive glass, then prepare one second hole transport monolayer with a thickness of 3 nm as the indirect contact layer, and finally prepare one third hole transport monolayer with a thickness of 0.1 nm as the direct contact layer; and the doping materials and ratios of each layer are the same as in the Example 1.

### Example 20:

This example is basically the same as the Example 1, except that in step 2), the dried FTO conductive glass is used as the first electrode layer, the magnetron sputtering method is utilized to prepare three first hole transport monolayers with each layer having a thickness of 3 nm as the non-direct contact layers on the FTO conductive glass, then prepare one second hole transport monolayer with a thickness of 3 nm as the indirect contact layer, and finally prepare one third hole transport monolayer with a thickness of 5 nm as the direct contact layer; and the doping materials and ratios of each layer are the same as in the Example 1.

### Example 21:

This example is basically the same as the Example 1, except that in step 2), the dried FTO conductive glass is used as the first electrode layer, the magnetron sputtering method is utilized to prepare three first hole transport monolayers with each layer having a thickness of 3 nm as the non-direct contact layers on the FTO conductive glass, then prepare one second hole transport monolayer with a thickness of 3 nm as the indirect contact layer, and finally prepare one third hole transport monolayer with a thickness of 10 nm as the direct contact layer; and the doping materials and ratios of each layer are the same as in the Example 1.

### Example 22:

This example is basically the same as the Example 1, except that in step 2), the dried FTO conductive glass is used as the first electrode layer, the magnetron sputtering method is utilized to prepare three first hole transport monolayers with each layer having a thickness of 3 nm as the non-direct contact layers on the FTO conductive glass, then prepare one second hole transport monolayer with a thickness of 3 nm as the indirect contact layer, and finally prepare one third hole transport monolayer with a thickness of 20 nm as the direct contact layer; and the doping materials and ratios of each layer are the same as in the Example 1.

### Example 23:

This example is basically the same as the Example 18, except that: in step 2), no doped cations are introduced into the non-direct contact layer, and only the doped cation Li⁺ is introduced into the indirect contact layer; and the rest is the same as in the example 18.

### Example 24:

This example is basically the same as the Example 18, except that in step 2), the dried FTO conductive glass is used as the first electrode layer, the magnetron sputtering method is utilized to prepare five nickel oxide layers with each layer having a thickness of 3 nm as the non-direct contact layers on the FTO conductive glass, then prepare one nickel oxide layer with a thickness of 3 nm as the indirect contact layer, and finally prepare one third hole transport monolayer with a thickness of 5 nm as the direct contact layer (the direct contact layer is the nickel oxide layer doped with Eu²⁺), and the doping ratio of the direct contact layer is the same as in the Example 18.

### Example 25:

This example is basically the same as the Example 1, except that in step 2), the dried FTO conductive glass is used as the first electrode layer, the magnetron sputtering method is utilized to prepare three first hole transport monolayers with each layer having a thickness of 3 nm as the non-direct contact layers on the FTO conductive glass, then prepare one second hole transport monolayer with a thickness of 2 nm as the indirect contact layer, and finally prepare one third hole transport monolayer with a thickness of 3 nm as the direct contact layer; and the doping materials and ratios of each layer are the same as in the Example 1.

### Contrast Example 1:

This contrast example is basically the same as the Example 1, except that: no reducing cations or doped cations are doped in the hole transport layer; that is, during preparing the non-direct contact layer, the indirect contact layer, and the direct contact layer in the hole transport layer, nickel oxide target material is used, and no reducing cations or doped cations are doped in the target material.

### Contrast Example 2:

This contrast example is basically the same as the Example 1, except that: no reducing cations are doped in the hole transport layer; that is, no reducing cations are doped in the target material when preparing the indirect contact layer and the direct contact layer in the hole transport layer.

### Testing methods:

### 1) Cation type and content testing:

X-ray photoelectron spectroscopy (XPS) was utilized to characterize the prepared direct contact layer, indirect contact layer, and non-direct contact layer; after collecting photoelectron pulse signals, an energy spectrum was plotted with photoelectron binding energy as the abscissa and relative intensity as the ordinate; after correction and fitting, the positions of peaks related to the nickel ions, the doped cations, and the reducing cations could be determined using standard cards, the valence states of the nickel ions, the doped cations, and the reducing cations could be confirmed (the photoelectron binding energy of elements is different under different valence states), and the ratio of the doped cations to the nickel ions as well as the ratio of the reducing cations to the nickel ions could be obtained based on the peak intensity.

### 2) Photovoltaic conversion efficiency test of perovskite cell:

The photoelectric conversion efficiency test was carried out on a perovskite cell device using a solar simulator under standard test conditions (total irradiance: 100 mW/cm², cell temperature: 25°C, spectral distribution: AM1.5G), and the readings were recorded using a Keithley 2400 series digital multimeter. The photoelectric conversion efficiency of the perovskite cell is calculated as follows: $\begin{matrix}PCE = Pout / Pin \\ = Voc \times Jsc \times \left[\left(Vmpp\times Jmpp\right)/\left(Voc\times Jsc\right)\right] / Pin \\ = Voc \times Jsc \times FF / Pin\end{matrix}$

In which, Pout, Pin, Voc, Jsc, Vmpp, Jmpp and FF respectively refer to an operating output power, an incident light power, an open circuit voltage, a short circuit current, the maximum power point voltage, the maximum power point current, and fill factor of the cell. The incident light power is 100 mW/cm². Voc, Jsc, Vmpp, and Jmpp are obtained using a digital multimeter, and FF=(Vmpp×Jmpp)/(Voc×Jsc).

The hole transport layer parameters and photoelectric conversion efficiency test results of the perovskite cell in each example and the contrast example are shown in Tables 1 and 2. In Tables 1 and 2, "Type of A ion" represents the type of the reducing cations in the direct contact layer and the indirect contact layer; "A/Ni molar ratio" represents the molar ratio of the reducing cations to the nickel element in the direct contact layer and the indirect contact layer; the "type of B ion" represents the type of the doped cations in the indirect contact layer; the "B/Ni molar ratio" represents the molar ratio of the doped cations to the nickel element in the indirect contact layer; the "type of C ion" represents the type of the doped cations in the non-direct contact layer; the "C/Ni molar ratio" represents the molar ratio of the doped cations to the nickel element in the non-direct contact layer; the "Normalized efficiency after 30 days of storage" represents the relative efficiency of the perovskite cell after 30 days of storage compared to the initial state of the perovskite cell, namely, the efficiency of the perovskite cell in the initial state is taken as 100%; and the "30-day storage" condition is: an unencapsulated perovskite cell is placed in a dry air environment with humidity ≤1% for 30 days under sunlight.

**Table 1**

| Items | Type of A ion | A/Ni molar ratio | Type of B ion | B/Ni molar ratio | Type of C ion | C/Ni molar ratio | Thickness of direct contact layer/nm | Thickness of indirect contact layer/nm | Photovoltaic conversion efficiency/% | Initial normalized efficiency/% | Normalized efficiency after 30 days of storage/% |
|---|---|---|---|---|---|---|---|---|---|---|---|
| Example 1 | Eu²⁺ | 0.005: 1 | Li⁺ | 0.0001:1 | Li⁺ | 0.02:1 | 3 | 3 | 19.1 | 100 | 91 |
| Example 2 | Eu²⁺ | 0.005: 1 | Li⁺ | 0.001:1 | Li⁺ | 0.001:1 | 3 | 3 | 19.3 | 100 | 91 |
| Example 3 | Eu²⁺ | 0.005: 1 | Li⁺ | 0.02: 1 | Li⁺ | 0.02:1 | 3 | 3 | 20.4 | 100 | 90 |
| Example 4 | Eu²⁺ | 0.005: 1 | Li⁺ | 0.1:1 | Li⁺ | 0.1:1 | 3 | 3 | 20.1 | 100 | 88 |
| Example 5 | Eu²⁺ | 0.005: 1 | Li⁺ | 0.15:1 | Li⁺ | 0.15:1 | 3 | 3 | 19.4 | 100 | 87 |
| Example 6 | Eu²⁺ | 0.005: 1 | Li⁺ | 0.2:1 | Li⁺ | 0.2:1 | 3 | 3 | 18.7 | 100 | 86 |
| Example 7 | Eu²⁺ | 0.0001: 1 | Li⁺ | 0.02:1 | Li⁺ | 0.02:1 | 3 | 3 | 18.7 | 100 | 78 |
| Example 8 | Eu²⁺ | 0.002: 1 | Li⁺ | 0.02:1 | Li⁺ | 0.02:1 | 3 | 3 | 19.1 | 100 | 85 |
| Example 9 | Eu²⁺ | 0.05: 1 | Li⁺ | 0.02:1 | Li⁺ | 0.02:1 | 3 | 3 | 19.3 | 100 | 92 |
| Example 10 | Eu²⁺ | 0.1: 1 | Li⁺ | 0.02:1 | Li⁺ | 0.02:1 | 3 | 3 | 18.5 | 100 | 94 |
| Example 11 | Eu²⁺ | 0.2: 1 | Li⁺ | 0.02:1 | Li⁺ | 0.02:1 | 3 | 3 | 18.1 | 100 | 95 |
| Example 12 | Yb²⁺ | 0.008: 1 | Mg²⁺ | 0.015:1 | Mg²⁺ | 0.015:1 | 3 | 3 | 20.2 | 100 | 90 |
| Example 13 | Yb²⁺ | 0.008: 1 | Mg²⁺ | 0.12:1 | Mg²⁺ | 0.12:1 | 3 | 3 | 19.1 | 100 | 88 |
| Example 14 | Yb²⁺ | 0.1: 1 | Mg²⁺ | 0.015:1 | Mg²⁺ | 0.015:1 | 3 | 3 | 18.2 | 100 | 89 |

**Table 2**

| Items | Type of A ion | A/Ni molar ratio | Type of B ion | B/Ni molar ratio | Type of C ion | C/Ni molar ratio | Thickness of direct contact layer/nm | Thickness of indirect contact layer/nm | Photovoltaic conversion efficiency/% | Initial normalized efficiency/% | Normalized efficiency after 30 days of storage/% |
|---|---|---|---|---|---|---|---|---|---|---|---|
| Example 15 | Ce³⁺ | 0.006: 1 | Sr²⁺ | 0.05:1 | Sr²⁺ | 0.05:1 | 3 | 3 | 20.6 | 100 | 91 |
| Example 16 | Ce³⁺ | 0.006: 1 | Sr²⁺ | 0.15:1 | Sr²⁺ | 0.15:1 | 3 | 3 | 19.6 | 100 | 89 |
| Example 17 | Ce³⁺ | 0.1: 1 | Sr²⁺ | 0.05:1 | Sr²⁺ | 0.05:1 | 3 | 3 | 18.5 | 100 | 90 |
| Example 18 | Eu²⁺ | 0.005: 1 | Li⁺ | 0.0001:1 | Li⁺ | 0.02:1 | 2 | 3 | 19.1 | 100 | 88 |
| Example 19 | Eu²⁺ | 0.005: 1 | Li⁺ | 0.0001:1 | Li⁺ | 0.02:1 | 0.1 | 3 | 19 | 100 | 69 |
| Example 20 | Eu²⁺ | 0.005: 1 | Li⁺ | 0.0001:1 | Li⁺ | 0.02:1 | 5 | 3 | 19.2 | 100 | 92 |
| Example 21 | Eu²⁺ | 0.005: 1 | Li⁺ | 0.0001:1 | Li⁺ | 0.02:1 | 10 | 3 | 18.8 | 100 | 93 |
| Example 22 | Eu²⁺ | 0.005: 1 | Li⁺ | 0.0001:1 | Li⁺ | 0.02:1 | 20 | 3 | 18.2 | 100 | 94 |
| Example 23 | Eu²⁺ | 0.005: 1(No A ion in indirect contact layer) | Li⁺ | 0.0001:1(No B ion in non-direct contact layer) | / | / | 2 | 3 | 18.9 | 100 | 87 |
| Example 24 | Eu²⁺ | 0.005: 1(No A ion in indirect contact layer) | / | / | / | / | 5 | 3 | 18.6 | 100 | 86 |
| Example 25 | Eu²⁺ | 0.005: 1 | Li⁺ | 0.0001:1 | Li⁺ | 0.02:1 | 3 | 2 | 19.1 | 100 | 90 |
| Contrast Example 1 | / | / | / | / | / | / | 3 | 3 | 17 | 100 | 60 |
| Contrast Example 2 | / | / | Li⁺ | 0.02:1 | Li⁺ | 0.02:1 | 3 | 3 | 18.7 | 100 | 58 |

As shown in Tables 1 and 2, the normalized photoelectric conversion efficiency of the perovskite cell in each example of the present application is relatively high after 30 days of storage compared to the initial state of the cell, indicating that the perovskite cell has good stability and long service life. Moreover, the perovskite cell has high photoelectric conversion efficiency.

In the perovskite cells in the Contrast Examples 1 and 2, the reducing cations were not added to the hole transport layers, and the normalized efficiency after 30 days of storage was significantly lower than that of the perovskite cell in the example of the present application. In addition, in the perovskite cells in the Contrast Example 2, the doped cations were not added to the hole transport layer, and the photoelectric conversion efficiency of the cell was further reduced compared to the Contrast Example 1.

The above description of various embodiments tends to emphasize the differences between each embodiment, and their similarities or common features can be cross-referenced. For the sake of brevity, they will not be repeated here.

It should be noted that the present application is not limited to the above embodiments. The above embodiments are merely examples, and any embodiments within the scope of technical solutions of the present application that have substantially the same configuration to the technical concept and achieve the same functional effects are included within the technical scope of the present application. In addition, without departing from the scope of the gist of the present application, various modifications that are made to the embodiments and conceivable to those skilled in the art, and other modes constructed by combining some of the constituent elements of the embodiments are also included in the scope of the present application.

## Claims

1. A perovskite cell, comprising:
a first electrode layer;
a hole transport layer which is arranged on one side of the first electrode layer and comprises nickel oxide and reducing cations;
a perovskite layer which is arranged on a side of the hole transport layer facing away from the first electrode layer; and
a second electrode layer which is arranged on a side of the perovskite layer facing away from the hole transport layer.

2. The perovskite cell according to claim 1, wherein the reducing cations comprise lanthanide metal ions.

3. The perovskite cell according to claim 2, wherein the lanthanide metal ions comprise one or more of Eu²⁺, Yb²⁺, Sm²⁺, Ce³⁺, Tb³⁺, or Pr³⁺.

4. The perovskite cell according to any one of claims 1 to 3, wherein a concentration of the reducing cations on the side of the hole transport layer facing away from the first electrode layer is greater than the concentration of the reducing cations on the side of the hole transport layer facing the first electrode layer.

5. The perovskite cell according to any one of claims 1 to 4, wherein the nickel oxide further comprises doped cations.

6. The perovskite cell according to claim 5, wherein the doped cations comprise one or more of Li⁺, Cs⁺, Rb⁺, Ag⁺, Mg²⁺, Ca²⁺, Zn²⁺, Sr²⁺, Ba²⁺, Fe²⁺, Fe³⁺, Co²⁺, Co³⁺, Cu⁺, Eu³⁺, Yb³⁺, Sm²⁺, Ce⁴⁺, Tb⁴⁺, Pr⁴⁺, Cu²⁺, or Nd³⁺.

7. The perovskite cell according to any one of claims 1 to 6, wherein the hole transport layer comprises a direct contact layer at the side facing the perovskite layer, and a non-direct contact layer at the side away from the perovskite layer; the direct contact layer comprises nickel oxide and the reducing cations; and the non-direct contact layer comprises nickel oxide.

8. The perovskite cell according to claim 7, wherein at least 60% of the reducing cations are distributed in the direct contact layer.

9. The perovskite cell according to claim 7 or 8, wherein a thickness of the direct contact layer is 0.1-20 nm.

10. The perovskite cell according to claim 9, wherein the thickness of the direct contact layer is 0.1-10 nm.

11. The perovskite cell according to claim 10, wherein the thickness of the direct contact layer is 2-10 nm.

12. The perovskite cell according to any one of claims 7 to 11, wherein a molar ratio of the reducing cations to a nickel element in the direct contact layer is (0.0001-0.2):1.

13. The perovskite cell according to claim 12, wherein the molar ratio of the reducing cations to the nickel element in the direct contact layer is (0.002-0.05):1.

14. The perovskite cell according to any one of claims 7 to 13, wherein the hole transport layer further comprises an indirect contact layer which is located between the direct contact layer and the non-direct contact layer; the indirect contact layer comprises nickel oxide and the reducing cations, or the indirect contact layer comprises nickel oxide, the reducing cations, and the doped cations.

15. The perovskite cell according to claim 14, wherein the thickness of the indirect contact layer is 0.1-20 nm.

16. The perovskite cell according to claim 15, wherein the thickness of the indirect contact layer is 0.1-10 nm.

17. The perovskite cell according to claim 16, wherein the thickness of the indirect contact layer is 0.1-5 nm.

18. The perovskite cell according to any one of claims 14 to 17, wherein in the indirect contact layer, the molar ratio of the reducing cations to the nickel element is (0.0001-0.2):1.

19. The perovskite cell according to claim 18, wherein in the indirect contact layer, the molar ratio of the reducing cations to the nickel element is (0.002-0.05):1.

20. The perovskite cell according to any one of claims 14 to 19, wherein if the indirect contact layer comprises the doped cations, the molar ratio of the doped cations to the nickel element in the indirect contact layer is (0.0001-0.2):1.

21. The perovskite cell according to claim 20, wherein in the indirect contact layer, the molar ratio of the doped cations to the nickel element is (0.001-0.1):1.

22. The perovskite cell according to any one of claims 14 to 21, wherein a density of each of the direct contact layer, the non-direct contact layer, and the indirect contact layer is independently 1%-100%.

23. A preparation method for the perovskite cell according to any one of claims 1 to 22, comprising the following step:
forming the first electrode layer, the hole transport layer, the perovskite layer, and the second electrode layer which are stacked in sequence; wherein
the hole transport layer comprises nickel oxide and the reducing cations.

24. The preparation method for the perovskite cell according to claim 23, wherein the hole transport layer is prepared by the following step:
preparing a plurality of hole transport monolayers in sequence on the first electrode layer, the plurality of hole transport monolayers being stacked on the first electrode layer, and at least the hole transport monolayer in direct contact with the perovskite layer comprising the reducing cations.

25. The preparation method for the perovskite cell according to claim 24, wherein in the hole transport monolayer close to the perovskite layer, the molar ratio of the reducing cations to nickel element is (0.0001-0.2):1.

26. The preparation method for the perovskite cell according to claim 25, wherein in the hole transport monolayer close to the perovskite layer, the molar ratio of the reducing cations to nickel element is (0.002-0.05):1.

27. The preparation method for the perovskite cell according to claim 24, wherein each hole transport monolayer independently contains or do not contain the doped cations.

28. The preparation method for the perovskite cell according to claim 27, wherein in the hole transport monolayer containing the doped cations, the molar ratio of the doped cations to the nickel element is (0.0001-0.2):1.

29. The preparation method for the perovskite cell according to claim 28, wherein in the hole transport monolayer containing the doped cations, the molar ratio of the doped cations to the nickel element is (0.001-0.1):1.

30. The preparation method for the perovskite cell according to any one of claims 24 to 29, wherein 2-50 hole transport monolayers are provided.

31. The preparation method for the perovskite cell according to any one of claims 24 to 30, wherein the thickness of each hole transport monolayer is 0.1-20 nm.

32. A photovoltaic module, comprising the perovskite cell according to any one of claims 1 to 22 or a perovskite cell prepared by the preparation method according to any one of claims 23 to 31.

33. A photovoltaic system, comprising the photovoltaic module according to claim 32.

34. An electrical apparatus, comprising the photovoltaic system according to claim 33.

35. A power generation apparatus, comprising the photovoltaic system according to claim 33.
